Europäisches Patentamt

European Patent Office

Office européen des brevets

(11) Publication number: **0 208 177**
**A2**

# EUROPEAN PATENT APPLICATION

(21) Application number: 86108340.0

(51) Int. Cl.4: **C25D 1/04**

(22) Date of filing: 19.06.86

(30) Priority: 05.07.85 US 751848

(43) Date of publication of application:
14.01.87 Bulletin 87/03

(84) Designated Contracting States:
BE DE FR GB IT LU NL SE

(71) Applicant: YATES INDUSTRIES, INC.
U.S. Highway 130
Bordentown New Jersey 08505(US)

(72) Inventor: Roberts, Derek A. K.
371 Nassau Street
Princeton N. J.(US)

(74) Representative: Patentanwälte Grünecker,
Kinkeldey, Stockmair & Partner
Maximilianstrasse 58
D-8000 München 22(DE)

(54) Ultrathin copper foil and process for producing such foil.

(57) A composite foil is provided which comprises an electrically conductive support layer treated to permit electrodeposition of a copper layer thereon, a first electrodeposited copper layer on the support layer of a thickness sufficient to form a matte surface, a thin layer of release agent on the matte surface, and a second electrodeposited copper layer of a non-self-supporting thickness.

EP 0 208 177 A2

## ULTRATHIN COPPER FOIL AND PROCESS FOR PRODUCING SUCH FOIL

### FIELD OF THE INVENTION

The present invention relates to composite foils which can be used in the manufacture of printed circuit elements and a method of making such composite foils.

### BACKGROUND OF THE INVENTION

Printed circuits are generally manufactured from copper clad laminates by an etching process. The copper clad laminates are commonly formed from copper foil and an insulating substrate bound to the matte surface of the copper foil. The circuit pattern is formed by removing a portion of the copper foil by etching. In the standard etching process, the copper surface is coated with a photoresist material. To ensure adhesion of the photoresist material to the exposed copper foil surface, the copper surface is first cleaned and roughened by scrubbing or chemical treatment. The photoresist layer is then covered with a mask defining the desired circuitry, and exposed to light, causing that portion representing the desired circuitry pattern to develop and harden. The undeveloped photoresist is washed away and the masked surface is then treated with etching solution to remove the unwanted, exposed portions of the copper.

During the removal of the unwanted copper, the etching solution frequently attacks the mask-protected circuitry which forms the desired wiring pattern. This problem, termed "undercutting," is particularly troublesome where it is desired to produce a circuit having very fine lines. One solution to this problem that has been used commercially is to employ a composite foil composed of a very thin layer of copper foil on a temporary carrier. While these composite foils reduce the undercutting problem, they cause difficulties in adhering the photoresist material to the ultrathin copper foil surface which are not encountered with the use of thicker foils. These difficulties occur because while thicker copper foil surfaces can be scrubbed or chemically etched after lamination to clean the copper surface and increase the roughness of the copper surface (thus providing a surface sufficiently rough for photoresist adhesion), ultrathin foils are too thin to be subjected to such roughening treatments.

An example of an ultrathin foil is described in British Patent No. 1,458,260, entitled "Thin Foil" to Adam W. Wolski. The foil comprised an ultrathin copper layer supported by a temporary aluminum carier which was separated from the aluminum by an intermediate anodized layer of aluminum oxide. The composite foil produced from this process resulted in a copper clad laminate that had a very smooth exposed surface because that surface conforms to the smooth surface of the aluminum carrier, thus making photoresist adhesion difficult.

Therefore, a need exists in the art for a composite foil which can be used to produce a laminate clad with an ultrathin copper foil surface sufficiently rough so that the photoresist material adheres to the copper foil surface.

Accordingly, it is an object of the present invention to provide a composite foil comprising an ultrathin copper layer and a carrier therefore which may be laminated to a resinous substrate to produce an ultrathin copper clad laminate with a roughened exposed copper surface that provides good photoresist adhesion.

This and other objects and advantages of the present invention will become more apparent in connection with the ensuing description and appended claims.

### SUMMARY OF THE INVENTION

The present invention solves the problem described above by providing a novel composite foil comprising an electrically conductive support layer treated to permit the electrodeposition of a copper layer thereon, a first electrodeposited copper layer formed on the support layer of a thickness sufficient to form a matte surface, a thin layer of release agent formed on said matte surface, and a second electrodeposited copper layer of a non-self-supporting thickness.

The support layer, first copper layer, and release coating, hereinafter called the "carrier layers", provide a carrier for the ultrathin copper foil, supporting the foil during handling and further processing and during the laminating process used to form the copper clad laminate. It also provides a release surface which permits clean and easy separation, without tearing, after the laminate has been formed.

The release coating or layer is formed of a material which is relatively resistant to attack by a copper acid plating electrolyte and permits clean and easy separation of the carrier layers from the non-self-supporting copper layer. In a preferred embodiment, the release layer is chromium. The release layer is sufficiently thick to permit release of the carrier layers from the composite foil and sufficiently thin so that the surface of the release layer on which the second copper layer is electrodeposited has a matte surface configuration similar to the surface of the first copper layer upon which the release layer was deposited.

The first electrodeposited copper layer is of a thickness sufficient to form a matte surface, approximately about 2 to about 5 microns. Since the surface of the the second electrodeposited layer in contact with the release layer (hereinafter "release layer facing surface") will conform to the surface characteristics of the layer on which it is deposited, the release layer facing surface will have a matte surface. Accordingly, when the composite foil is laminated and the copper clad laminate has been separated from the carrier layers, the release layer facing surface of the second copper layer will be exposed and will have a matte surface sufficiently rough so that no additional treatment is neccessary for good photoresist adhesion.

The present invention also provides a process for the manufacture of the composite foil comprising electrodepositing on a support layer, treated to permit electrodeposition of a copper layer thereon, a first layer of copper of a thickness sufficient to form a matte surface, coating the matte surface of the first copper layer with a thin layer of release agent, and electrodepositing on the layer of release agent a second copper layer of a non-self-supporting thickness.

The copper clad laminates of the present invention are produced by conventional means by superimposing the composite foil on a substrate of a resinous insulating material with the ultrathin copper layer in contact with the insulating substrate, and laminating the assembly under heat and pressure. During lamination, the carrier layer serves as a barrier to prevent penetration through the ultrathin layer by the resin of the substrate.

## DETAILED DESCRIPTION OF THE INVENTION

As previously noted, the present invention provides a composite foil comprising an electrically conductive support layer treated to permit electrodeposition of a copper layer thereon, two electrodeposited copper layers, and a thin layer of release agent intermediate to the two copper layers. In a preferred embodiment, the invention provides a composite foil comprising an aluminum support layer, an electrochemically formed copper strike on the aluminum support layer, a first electrodeposited copper layer formed on the copper strike of a thickness sufficient to form a matte surface, a thin layer of release agent formed on the matte surface, and a second electrodeposited copper layer of a non-self-supporting thickness. In accordance with this invention, the surface of the second copper layer not in contact with the release layer (hereinafter "outer surface") is laminated to an insulating substrate, the carrier layer is removed, and the resultant copper clad laminate produced has an ultrathin copper layer with a roughened surface to allow for good photoresist adhesion.

The electrically conductive aluminum support layer should have a thickness of less than 200 microns, preferably from about 30 to about 40 microns, and must be treated to prevent the formation of oxides on the aluminum surface, which if formed, make the electrodeposition of a suitable copper layer thereon difficult, if not impossible. A number of treatments are well known in the art. One type of process is zincate immersion, of which there are a variety known in the art, such as that described in S. Wernick, "The Surface Treatment and Finishing of Aluminum and Its Alloys", Robert Draper Ltd. (1964) pp. 624-625.

In a preferred zincate immersion process, the support layer is subjected to a four step zincating process. The aluminum layer is cleaned and etched with a 5% hydrofluoric acid solution for about 60 seconds at room temperature. The cleaned and etched aluminum layer is then zincated at a temperature of about 90° to 100°F for approximately 30 seconds with the following solution:

100g/l sodium hydroxide,

40g/l Rochelle salt,

40g/l zinc sulfate,

30g/l nickel sulfate,

5g/l copper sulfate, and

4g/l ferric nitrate.

The zinc layer is then stripped with a 35% nitric acid solution at room temperature for about 10 seconds. A second zincate layer, identical to the first zincate layer, is formed thereon.

An electrochemically formed copper strike may also be formed on the aluminum support layer to permit electrodeposition of the subsequent copper layer. An appropriate thickness for the copper strike is from about 1 microns to about 2 microns, resulting in an area weight from about 9 g/m² to about 18 g/m², preferably from about 1.4 to about 1.8 microns, with an area weight of about 13 g/m² to about 16 g/m². The following table sets forth exemplary conditions and the solution for use in forming the copper strike:

## Copper Strike

|                             | Exemplary    | Preferred  |
| --------------------------- | ------------ | ---------- |
| Electrolyte                 |              |            |
|   Copper (as pyrophosphate) | 12-30 g/l    | 15 g/l     |
|   Oxalic acid               | 40-80 g/l    | 60 g/l     |
| pH                          | 7-9          | 8          |
| Temp                        | 110-150°F    | 130°F      |
| Current Density             | 30-40 ASF    | 36 ASF     |
| Time                        | 80-150 sec.  | 120 sec.   |

In a preferred embodiment, both zincate immersion and the formation of a copper strike are used to permit the electrodeposition of the copper layer on the support layer. The support layer is first subjected to a zincate immersion process and a copper strike is formed in an alkaline bath on the zincated surface. The copper strike protects the zinc layer from being dissolved by the acidic high-speed copper plating bath used to form the first electrodeposited copper layer. If no copper strike is present, the acidic bath will dissolve the zincate layer.

The first electrodeposited copper layer, which is formed on the copper strike, must be of a thickness sufficient to form a matte surface. The first copper layer should have a thickness of at least about 2 microns and an area weight of about 18 g/m². A thickness of greater than 5 microns with an area weight of about 45 g/m² is the maximum which is needed. Preferably the layer should have a thickness of about 3 to about 4 microns, with an area weight of about 27 g/m² to about 36 g/m². Exemplary conditions and the electrolyte for use in forming the first electrodeposited copper layer are set forth below:

## First Copper Layer

|  | Exemplary | Preferred |
|---|---|---|
| **Electrolyte** | | |
| Copper Sulphate | 150-250 g/l | 200 g/l |
| Sulphuric acid | 20-40 g/l | 30 g/l |
| pH | $< 1$ | $< 1$ |
| Temperature | 75-120°F | 100°F |
| Current Density | 60-80 ASF | 72 ASF |
| Time | 80-150 sec. | 120 sec. |

The second electrodeposited copper layer has a non-self-supporting thickness, and will have a thickness of less than 17 microns. It will generally range in thickness from about 2 to about 12 microns and have an area weight ranging from about 27 $g/m^2$ to about 108 $g/m^2$, preferably about 4.5 to about 5.5 microns, with an area weight of about 40 $g/m^2$ to about 50 $g/m^2$. Exemplary conditions and the electrolyte for use in forming the second electrodeposited copper layer are set forth below:

## Second Copper Layer

|  | Exemplary | Preferred |
|---|---|---|
| **Electrolyte** | | |
| Copper Sulphate | 150-250 g/l | 200 g/l |
| Sulphuric acid | 20-40 g/l | 30 g/l |
| pH | $< 1$ | $< 1$ |
| Temperature | 75-120°F | 100°F |
| Current Density | 60-80 ASF | 72 ASF |
| Time | 150-220 sec. | 180 sec. |

The release layer, located intermediate to the first and second electrodeposited copper layers may be any material which is sufficiently conductive and sufficiently uniform in its surface characteristics to allow the electrodeposition of a continuous second copper layer thereon and which allows the support layer, and the first copper layer to be mechanically stripped from a laminate without tearing the second ultrathin copper layer. A suitable release layer is described in U.S. Patent No. 3,998,601 entitled "Thin Foil" to Yates et al., which is hereby incorporated by reference. Suitable release layers include oxides and salts such as sulfides, chromates and the like. Coatings of such compounds may be formed on the surface of the carrier either by electrolytic deposition or by simple immersion in an appropriate solution.

Metals are preferred release agents, most preferably lead, nickel, chromium and silver. The release layer should have a thickness sufficient to permit release of the carrier layers from the composite foil and be sufficiently thin so that the surface of the release layer on which the second copper layer is electrodeposited has the same matte surface configuration as the first copper layer. Thus, the release layer should have a thickness of approximately 0.5 to about 1.5 microns and an area weight of about 4.5 g/m² to 13.5 g/m², preferably about 0.8 microns to about 1.25 microns, with an area weight of about 5.8 g/m² to about 9.0 g/m².

Chromate release layers may be formed electrolytically in aqueous electrolytes containing hexavalent chromium ions or simply by immersion in like solutions. Suitable electrolytic solutions may be formed by the dissolution in water of chromium salts such as chromium trioxide, potassium dichromate, sodium dichromate, ammonium dichromate, and potassium chromate. The most commonly used compound is chromium trioxide which is also known as "anhydrous chromic acid" and which is available commercially in flake form. Additives such as sulphuric acid or sulphates, hydrochloric acid or chlorides, nitric acid or nitrates, or acetates may optionally be added to the electrolyte. The following table sets forth exemplary conditions and the electrolyte for the formation of a chromium release layer:

## Release Layer

| | Exemplary | Preferred |
|---|---|---|
| **Electrolyte** | | |
| Chromium Trioxide | 200-300g/l | 250g/l |
| Sulphuric acid | 2-3 g/l | 2.5g/l |
| pH | $\angle$ 2 | $\angle$ 2 |
| Temperature | 60-80°F | 70°F |
| Current Density | 120-160 ASF | 140 ASF |
| Time | 80-159 seconds | 120 seconds |

The outer surface of the second copper layer may be subjected to any treatment known in the art to increase its bond strength when it is laminated to a substrate.

The composite foil of the present invention may be laminated to a supporting substrate by any conventional procedure. In these procedures the foil is first superimposed on top of a resinous insulating substrate. The foil-substrate assembly is then placed in a conventional laminating press and subjected to heat and pressure to form a laminate. After cooling, the carrier layers may be peeled off leaving a laminate clad with an ultrathin layer of copper with a roughened surface to provide good adhesion. The laminate is suitable for the production of printed circuit elements.

As will be apparent to those skilled in the art, the particular substrate used will vary depending upon the use for which the laminate is intended and the service conditions under which it will be used. Particularly appropriate substrates which adapt the laminate for use in forming printed circuits include non-flexible supports such as Teflon-impregnated fiberglass ("Teflon" is the trademark of E.I. DuPont de Nemours & Co. for polytetrafluoroethylene), "Kel-F" impregnated fiberglass ("Kel-F" is a trademark of Minnesota Mining & Mfg. Co. for certain fluorocarbon products including polymers of trifluorchloroethylene and certain copolymers), epoxy-impregnated fiberglass and the like. Flexible substrates may also be used and may include polyimides such as those known under the designation "Kapton" and "H-Film" (both are manufactured by E.I.Dupont de Nemours & Co. and are polyimide resins produced by condensing a pyromellitic anhydride with an aromatic diamine).

After lamination and removal of the carrier layers, the exposed copper foil surface is coated with photoresist material, a photographic negative of the circuit pattern is superimposed on the material, and the material is then exposed to ultraviolet light, which hardens the photoresist material.

The following example further illustrates preferred operations within the scope of the present invention.

Example 1

An aluminum support layer is cleaned and etched in 5% hydrofluoric acid for 60 seconds at room temperature. The layer is then zincated to form a first zincate layer at a temperature of about 90°-100°F for 30 seconds in the following solution:

100g/l sodium hydroxide,

40g/l Rochelle salt,

40g/l zinc sulfate,

30g/l nickel sulfate,

5g/l copper sulfate, and

4g/l ferric nitrate.

The zincate layer is stripped by immersion in 35% nitric acid for 10 seconds at room temperature. The support layer is zincated again under the same conditions as were used to form the first zincate layer.

An electrochemically formed copper strike is formed on the zincated support layer at a temperature of 130°F, a current density of 35 ASF at a pH of about 5.5-6.0 by immersion in the following solution for 120 seconds:

15g/l Copper (as pyrophosphate)

60/gl oxalic acid

A first copper layer is electrodeposited on the copper strike at a temperature of 100°F, a current density of 72 ASF by immersion in the following solution for 120 seconds:

200g/l Copper sulfate

300g/l suphuric acid

The release layer is formed on the first copper layer at a temperature of 70°F, a current density of 140 ASF by immersion in the following solution for 120 seconds:

250g/l chromium trioxide

2.5g/l sulphuric acid

The second copper layer is formed on the release layer by immersion in the following solution for 180 seconds, at a temperature of 100°F and a current density of 72 ASF:

200g/l copper sulfate

30g/l sulphuric acid

The invention may be embodied in other specific forms without departing from the spirit or essential characteristics thereof. The present embodiments are therefore to be considered in all respects as illustrative and not restrictive, the scope of the invention being indicated by the appended claims rather than by the foregoing description, all changes which come within the meaning and range of equivalency of the claims are therefore intended to be embraced therein.

**Claims**

1. A composite foil comprising:

(a) an electrically conductive support layer treated to permit the electrodeposition of a copper layer thereon;

(b) a first electrodeposited copper layer on said support layer of a thickness sufficient to have a matte surface;

(c) a thin layer of release agent formed on said matte surface; and

(d) a second electrodeposited copper layer of a non-self supporting thickness.

2. The composite foil of claim 1 wherein said support layer comprises aluminum.

3. The composite foil of claim 2 wherein said support layer is treated to permit electrodeposition of said first copper layer by the addition of an electrochemically formed copper strike on said support layer.

4. The composite foil of claim 2 wherein said support layer is treated to permit electrodeposition of said first copper layer with a zincate immersion process.

5. The composite foil of claim 3 wherein said copper strike has a thickness of from about 1 to 2 microns.

6. The composite foil of claim 1 wherein said first copper layer has a thickness of about 2 to 5 microns.

7. The composite foil of claim 1 wherein said second copper layer has a thickness of from about 2 to 12 microns.

8. The composite foil of claim 1 wherein said support layer has a thickness of from about 30 to 40 microns.

9. The composite foil of claim 1 wherein said release agent is selected from the group consisting of sulfides, chromates, and oxides.

10. The composite foil of claim 1 wherein said release agent is a metal.

11. The composite foil of claim 1 wherein said release agent is a metal selected from the group consisting of chromium, lead, nickel, and silver.

12. The composite foil of claim 1 wherein said release agent is chromium.

13. A laminate comprising the composite foil of claim 1, the outer surface of said second copper layer being bonded to a resinous insulating substrate.

14. A process for forming a composite foil suitable for use in the manufacture of printed circuits comprising:

(a) electrodepositing a first layer of copper of a thickness sufficient to form a matte surface onto an electrically conductive support layer treated to permit said electrodeposition;

(b) coating the matte surface of said first copper layer with a thin layer of a release agent; and

(c) electrodepositing on said layer of release agent a seond copper layer of a non-self supporting thickness.

15. The process according to claim 14 wherein said support layer comprises aluminum.

16. The process according to claim 15 wherein said support layer is treated to permit electrodeposition of said first copper layer by the addition of an electrochemically formed copper strike on said support layer.

17. The composite foil of claim 15 wherein said support layer is treated to permit electrodeposition of said first copper layer with a zincate immersion process.

18. The process according to claim 14 wherein said release agent is selected from the group consisting of sulfides, chromates, and oxides.

19. The process according to claim 14 wherein said release agent is a metal.

20. The process according to claim 14 wherein said release agent is a metal selected from the group consisting of chromium, lead, nickel, and silver.

21. The process according to claim 14 wherein said release agent is chromium.

22. The process according to claim 21 wherein the conditions for forming said release agent layer, and said first and second copper layers are approximately as follows:

|  | Release Agent Layer | First Copper Layer | Second Copper Layer |
|---|---|---|---|
| Electrolyte | 200–300g/1 Chromium Trioxide 2–3g/1 Sulphuric Acid | 150–250g/1 Copper Sulphate 20–40g/1 Sulphuric Acid | 150–250g/1 Copper Sulphate 20–40g/1 Sulphuric Acid |
| Electrolyte Temperature | 60–80°F | 75–120°F | 75–120°F |
| Cathode Current Density | 120–160 ASF | 60–80 ASF | 60–80 ASF |
| Deposition Time | 80–150 sec. | 80–150 sec. | 150–220 sec. |

23. The process according to claim 22 wherein the conditions for forming said release agent layer, and said first and second layers are approximately as follows:

|  | Release Agent Layer | First Copper Layer | Second Copper Layer |
|---|---|---|---|
| Electrolyte | 250g/l Chromium Trioxide 2.5g/l Sulphuric Acid | 200g/l Copper Sulphate 30g/l Sulphuric Acid | 200g/l Copper Sulphate 30g/l Sulphuric Acid |
| Electrolyte Temperature | 70°F | 100°F | 100°F |
| Cathode Current Density | 140 ASF | 72 ASF | 72 ASF |
| Deposition Time | 120 sec. | 120 sec. | 180 sec. |

24. The process according to claim 16 wherein the conditions for forming said copper strike are approximately as follows:

| Electrolyte | 12-30g/l Copper (as pyrophosphate) 40-80g/l Oxalic Acid |
|---|---|
| Electrolyte Temperature | 110-150°F |
| Cathode Current Density | 30-40 ASF |
| Deposition Time | 80-150 sec. |

25. The process according to claim 16 wherein the conditions for forming said copper strike are approximately as follows:

| Electrolyte | 15g/l Copper (as pyrophosphate) 60g/l Oxalic Acid |
|---|---|
| Electrolyte Temperature | 130°F |
| Cathode Current Density | 36 ASF |
| Deposition Time | 120 sec. |

26. The process according to claim 14 wherein said release agent permits said support layer, said first copper layer, and said release agent layer to be separated from said second copper layer without tearing.

27. The process of claim 14 wherein the outer surface of said second copper layer is roughened in any conventional manner.

28. The process of claim 27 wherein an insulating substrate is laminated to said roughened outer second copper layer under heat and pressure.

29. A composite foil produced in accordance with the process of claim 14.

30. A process of forming a copper clad laminate suitable for use in the manufacture of printed circuits comprising superimposing the composite foil of claim 1 on a resinous insulating substrate with said second copper layer in contact with said substrate and laminating said composite foil to said substrate.

31. A composite foil comprising:
(a) a zincated aluminum support layer;
(b) an electrochemically formed copper strike on said support layer;
(c) a first electrodeposited copper layer on said copper strike of a thickness sufficient to have a matte surface;
(d) a thin layer of release agent formed on said matte surface; and
(e) a second electrodeposited copper layer of a non-self supporting thickness.

32. A process for forming a composite foil suitable for use in the manufacture of printed circuits comprising:
(a) subjecting an aluminum support layer to a zincate immersion process;
(b) electrochemically forming on said support layer a copper strike;
(c) electrodepositing a first layer of copper of a thickness sufficient to form a matte surface onto said copper strike;
(d) coating the matte surface of said first copper layer with a thin layer of release agent; and
(e) electrodepositing on said layer of release agent a second copper layer of a non-self supporting thickness.